# EUROPÄISCHE PATENTSCHRIFT

(11) **EP 1 084 457 B1**
(45) Veröffentlichungstag und Bekanntmachung des Hinweises auf die Patenterteilung: **26.10.2005**
(21) Anmeldenummer: 99914487.6
(22) Anmeldetag: 08.03.1999
(51) Int. Cl.: G03F 7/075, C04B 41/91

(54) **VERFAHREN ZUR HERSTELLUNG VON KLEIN- UND MIKROTEILEN AUS KERAMIK**
METHOD FOR PRODUCING SMALL AND MICRO-SIZED CERAMIC PARTS
PROCEDE POUR PRODUIRE DES ELEMENTS EN CERAMIQUE DE TAILLE REDUITE OU DE L'ORDRE DU MICRON

(30) Priorität: 09.04.1998 DE 19815978
(43) Veröffentlichungstag der Anmeldung: 21.03.2001
(73) Patentinhaber: Forschungszentrum Karlsruhe GmbH, 76133 Karlsruhe (DE)
(72) Erfinder: HANEMANN, Thomas, D-76297 Stutensee (DE); HAUSSELT, Jürgen, D-76726 Germersheim (DE)
(74) Vertreter: Rückert, Friedrich
(86) Internationale Anmeldenummer: PCT/EP1999/001476
(87) Internationale Veröffentlichungsnummer: WO 1999/053379

(56) Entgegenhaltungen:
- EP-A- 0 510 872
- US-A- 5 639 413

## Beschreibung

Die Erfindung betrifft ein Verfahren zur Herstellung von Klein- und Mikroweilen aus Keramik durch Lithographie.

Eine Formgebung bzw. Bearbeitung (z. B. Mikrostrukturierung) von keramischen Materialien ist nach dem Sintern aufgrund der Härte bzw. Sprodheit weitestgehend ausgeschlossen. Daher müssen Formgebungsverfahren entwickelt werden, bei denen das keramische Ausgangsmaterial entweder in einem niedrigviskosen organischen bzw. anorganischen Lösungsmittel oder in einer wachs- bzw. thermoplastischen Kunststoffmatrix ungesintert vorliegt. Keramische Mikrostrukturen mit strukturellen Details < 100 µm und einem Aspektverhältnis (Verhältnis Strukturhöhe zu lateralen Abmessungen) größer 1 lassen sich daher z. Z. nur mit relativ aufwendigen Verfahren herstellen. Das LIGA-Verfahren (Röntgentiefenlithographie, Galvanoformung und Abformung), entwickelt am Forschungszentrum Karlsruhe, erlaubte bis vor kurzem, unter Verwendung von PMMA-Resistmaterialien, nur die direkte Herstellung von Mikrostrukturen aus Metall und Kunststoff. Diese Kunststoffmikrostrukturen lassen sich als verlorene Negativformen in einem weiteren Verfahrensschritt mittels Foliengießen, Prägen, Schlickerpressen oder Zentrifugalabformung in Keramik umkopieren [1]. Die Weiterentwicklung des keramische Spritzgießens für die Anforderungen der Mikroabformverfahren (Maschinentechnik, Pulvergröße, Bindersysteme, etc.) führte zum keramischen Heißgießen (Wachse als Binder) bzw. zum keramischen Mikrospritzgießen (Thermoplaste bzw. Thermoplaste/Wachs-Mischungen als Binder) [2,3]. Die organischen Binder müssen bei erhöhter Temperatur entfernt (entbindert) und das verbleibende Pulvergefüge zum stabilen mikrostrukturierten Formteil gesintert werden. Aufgrund der für das Heißgießen bzw. Spritzgießen zwingend notwendigen Fließfähigkeit des Keramik-Pulver-Gemisches (Feedstock) ist nur ein relativ niedriger Keramikanteil (50 - 70 Volumenprozent) möglich. Dies resultiert in einem Sinterschrumpf von 30 - 50 Volumenprozent des Formteils, welcher bei der Bauteilauslegung berucksichtigt werden muß. Die Verwendung von präkeramischen Polymermaterialien als Binder, welcher nach der Formgebung durch Erhitzen des Formteils auf erhöhte Temperaturen zur Keramik pyrolisiert, reduziert den Sinterschrumpf [2]; allerdings zeichnen sich diese präkeramischen Polymere weitestgehend durch eine chemische Instabilität gegen Luftfeuchtigkeit aus, so daß deren Anwendung im Spritzgießen bzw. Schlickergießen nur unter Laborbedingungen durchgeführt wurde [4]. Diese Verfahren benötigen im Gegensatz zu der im folgenden Beschriebenen eine (mikro-)struk-turtragende Masterstruktur aus Metall (Formeinsatz) oder Kunststoff (verlorene Form). Im letztgenannten Fall wird die Masterstruktur zusammen mit dem Formteil im festen Verbund zum keramischen Bauteil pyrolisiert.

In der Mikroelektronik und in der Mikrotechnik sind strahlungsempfindliche Kunststoffe oder Polymere bekannt, welche bei lithographischen Verfahren als Photoresist eingesetzt werden und nach Bestrahlung ihre Löslichkeit ändern. In der Lithographie zur Herstellung von Mikrostrukturen sind prinzipiell vier Verfahrensschritte notwendig, nämlich das Belacken (SpinCoaten), das bildhafte Belichten mit elektromagnetischer (aktinischer) Strahlung durch eine strukturtragende Maske, das Entwickeln, sowie zusätzlich meist eine nachgeschaltete thermische Behandlung bei erhöhter Temperatur zur Entfernung von Lösungsmittelresten im Polymerfilm und zur Verbesserung der Haftung auf dem Substrat. Im allgemeinen werden durch die Belichtung Polymerketten zerstört und damit das Molekulargewicht des Polymers vermindert, so daß ein vorher in entsprechenden organischen Lösungsmitteln unlösliches Polymer eine erhöhte Löslichkeit gegenüber dem unbelichteten Material aufweist. Nach dem Entwicklungsprozeß verbleibt das unbelichtete Polymer, welches das zuvor zweidimensionale Reliefbild der Maske in eine dreidimensionale Polymerstruktur überträgt, auf dem Substrat. Homogene Schichten mit einer Dicke über 100 µm lassen sich mit solchen Positivresists herstellen. Die Bestrahlung von Negativresistmaterialien führt zur Quervernetzung durch Polymerisation bzw. Polykondensation der Polymere bzw. Oligomere; die Löslichkeit wird dadurch erheblich reduziert. Das Entwickeln mit einem Lösungsmittel führt daher zur inverser. Maskenstruktur, da die unbelichteten Bereiche des Resists herausgelöst werden. Durch diese Verfahren lassen sich direkt Kunststoffmikrostruren lithographisch herstellen.

Präkeramische Polymere werden i. a. zur Herstellung von keramischen Fasern aus z. B. Siliziumcarbid, Siliziumnitrid, Siliziumcarbonitrid u.a. verwendet [5]. Die Behandlung der präkeramischen Polymere mit feuchter Luft oder bei erhöhter Temperatur (unter 500 °C) führt zu einer Quervernetzung und damit zu einer Unlöslichkeit in Lösungsmitteln. Anschließend erfolgt die Konversion zur Keramik bei Temperaturen von 1000 - 1200 °C. Präkeramische Polymere lassen sich ebenfalls mit elektromagnetischer Strahlung, wie z. B. UV-Strahlung, Röntgenstrahlung oder Elektronen, aushärten. Die UV-induzierte Quervernetzung von Polysilazanen in einer oxidierenden Atmosphäre (Luft, Sauerstoff) bei einer Temperatur unter 200 °C unter Verwendung einer Photomaske zur Musterherstellung wird beispielsweise zur Herstellung einer temporären Schutzschicht (Dicke kleiner 1 µm) auf Halbleiterelementen u.ä. eingesetzt [6]. Nach diesem oxidativen Verfahren hergestellten Keramiken weisen aufgrund eines erhöhten Sauerstoffgehalts eine geringe mechanische und thermische Stabilität aus.

EP-A-0510872 offenbart ein lithographisches Verfahren zur Herstellung von keramischer Beschichtungen, das die Merkmale a)-c) des Anspruchs 1 der vorliegenden Anmeldung umfaßt. Eine Pyrolyse bei 110°C-1000°C wird auch durchgeführt.

Aufgabe der Erfindung ist es, ein Verfahren anzugeben, mit dem keramische Strukturen mit großer thermischer und mechanischer Stabilität erzeugt werden können.

Gelöst wird diese Aufgabe durch die Merkmale des Patentanspruchs 1. Die Unteransprüche beschreiben voteilhafte Ausgestaltungen des Verfahrens.

Das hier vorliegende Verfahren erlaubt die direkte Herstellung von keramischen Mikrostrukturen unter Umgehung eines Abformzwischenschrittes durch Röntgentiefen- bzw. UV-Lithographie aus präkeramischen Polymeren. Die im folgenden beschriebenen Prozeßschritte werden bei Raumtemperatur (25 °C) durchgeführt:
*SpinCoating:* Das präkeramische Polymer bzw. dessen Losung in einem Lösungsmittel (z. B. Toluol, Xylol) wird auf ein hochtemperaturfestes Substrat (z. B. 4"-Aluminiumoxid-Wafer) aufgeschleudert. Die gewünschte Schichtdicke läßt sich über die Schleuderbedingungen (Anfahrrampe, Drehzahl) einstellen. Anschließend muß der Film getrocknet werden, um Lösungsmittelreste zu entfernen. Ein Backen des Filmes bei erhöhter Temperatur ist unbedingt zu vermeiden.
*Belichtung:* Hochparallele Röntgen- bzw. UV-Strahlung kann zur Belichtung des Polymerfilmes durch eine Lithographiemaske verwendet werden. Diese hochparallele Röntgenstrahlung kann z. B. auch durch ein Synchrotron erzeugt werden. Die bevorzugte Wellenlänge sollte kleiner sein als 1 nm.
*Entwicklung*/*Ätzen:* Nach dem Belichtungsschritt werden die unbelichteten Bereiche des Filmes durch ein Lösungsmittel (z. B. Aceton, Chloroform, Dioxan, Isopropanol, Toluol) entfernt. Dabei ist auf eine hohe Lösungsselektivität zu achten.
*Pyrolyse:* Das ungelöste präkeramische Polymer wird unter Schutzgas bzw. Reaktivgas (Helium, Argon, Stickstoff, Ammonik) oder im Vakuum einer Pyrolyse zur Keramik unterworfen.
*Sintern:* Ein stabiler Formkörper wird nach einem Sinterprozeß bei Temperaturen bis zu 2000 °C erhalten.

Diese Prozeßkette vereinigt die hervorragenden Strukturierungsmöglichkeiten von Polymeren mit den günstigen mechanischen, thermischen und chemischen Eigenschaften der Funktionskeramik und stellt ein neues, direktes Verfahren zur Herstellung keramischer Mikrostrukturen dar. Hochtemperaturfeste und chemisch inerte keramische Mikrobauteile für Anwendungen z. B. in der chemischen Mikroverfahrenstechnik (keramische Reaktoren, Mischer, etc.) können direkt und preisgünstig mittels Lithographieverfahren hergestellt werden. Daneben erlaubt das oben beschriebene Verfahren erstmals ein Rapid Prototying von mikrostrukturierten keramischen Komponenten, da CAD-Daten direkt mittels Lithographie in einen keramischen Prototypen umgewandelt werden können.

Die Erfindung wird im folgenden anhand dreier Ausführungsbeispiele näher erläutert:

### Beispiel 1:

Aluminiumoxidsubstrate (Durchmesser 30 mm) wurden mit einer frisch hergestellten Polycarbosilazanlösung (80 Gewichts% in Toluol) mittels SpinCoating beschichtet. Nach einer Polymeralterung an Luft (2 Tage) wurde anschließend mit einer UV-Belichtungsanlage Uvaprint 150 CM (H-Strahler) durch eine UV-Lithographiemaske bestrahlt (20 - 80 min). Als Teststruktur wurde eine einfache Kreuzstruktur gewählt, die kleinsten strukturellen Details weisen eine Größe von 50 µm auf. Im Anschluß wurden die Proben auf Raumtemperatur abgekühlt und sofort in Aceton entwikkelt (Verweilzeit im Entwicklungsbad 2 - 30 min, je nach vorheriger Belichtungszeit). Die nach dem Entwicklungsprozeß verbliebenen Mikrostrukturen wurden unter einer Stickstoffatmosphäre bei 1000 °C zur Siliziumcarbonitrid-Keramik pyrolisiert. Anschließend erfolgte der Sinterprozeß bei 1700 °C

### Beispiel 2:

Standard-Aluminiumoxid-Wafer (Durchmesser 4") wurden mit einer frisch hergestellten Polycarbosilazanlösung (80 Gewichts% in Toluol) mittels SpinCoating (Schichtdicke 40 µm) beschichtet. Die Polymerfilme wurden nach der Herstellung einen Tag an Luft gealtert und anschließend unter Stickstoff aufbewahrt. Unter Verwendung einer Röntgentiefenlithographiemaske (Teststrukturen: Kreisringe unterschiedlicher Dicke) wurden die beschichteten Wafer an einer Synchrotronstrahlungsquelle mit Röntgenstrahlung (Wellenlänge ≤ 1 nm) bestrahlt (Tiefendosis 4 - 12 kJ/cm³) und anschließend sofort in Chloroform entwickelt (1 - 10 min, jeweils nach vorheriger abgelagerter Tiefendosis). Strukturelle Details < 70 µm konnten nach dem Entwicklungsprozeß in sehr guter Qualität erhalten werden. Die Pyrolyse erfolgte in der unter Beispiel 1 beschriebenen Weise zur keramischen Mikrostruktur. Anschließend erfolgte der Sinterprozeß bei 1700 °C. Die Identifizierung der Siliziumcarbonitrid-Keramik erfolgte mittels EDX.

### Beispiel 3:

Standard-Aluminiumoxid-Wafer (Durchmesser 4") wurden mit einer frisch hergestellten Polycarbosilazanlösung (80 Gewichts% in Toluol) mittels SpinCoating (Schichtdicke 40 µm) beschichtet. Die Polymerfilme wurden nach der Herstellung ein Tag an Luft gealtert und anschließend unter Stickstoff aufbewahrt. Unter Verwendung einer Röntgentiefenlithographiemaske (Teststrukturen: Kreisringe unterschiedlicher Dicke) wurden die beschichteten Wafer an einer Synchrotronstrahlungsquelle bestrahlt (Tiefendosis 4 - 12 kJ/cm³) und anschließend sofort in Chloroform entwickelt (1 - 10 min, jeweils nach vorheriger abgelagerter Tiefen-dosis). Strukturelle Details < 70 µm konnten nach dem Entwicklungsprozeß in guter Qualität erhalten werden. Die Pyrolyse erfolgte in einer Ammonikatmosphäre bei 1000 °C zur Mikrostruktur. Die Sinterung erfolgte analog wie bei den anderen Beispielen.Die mikrostrukturierte Keramik wurde mittels EDX als Siliziumnitrid identifiziert.

### Literatur

**[1]** J. Ritzhaupt-Kleissl, Keramik in der Mikrotechnik - Werkstoffe, Verfahren und Anwendungen, 3. *Statuskolloquium des Pro*jektes *Mikrosystemtechnik*, 02./03.04.1998, Karlsruhe.
**[2]** Stadel, H. Freimuth, V. Hessel, M. Lacher, Abformung keramischer Mikrostrukturen durch die LIGA-Technik, *Keram. Z*., **48(12),** 1112ff, (1996).
**[3]** Piotter, T. Benzler, J. Haußelt, R. Ruprecht, MIM und CIM - Neue pulvertechnologische Verfahren in der Mikrotechnik, 3. *Statuskolloquium des Projektes Mikrosystemtechnik*, 02./03.04.1998, Karlsruhe.
**[4]** Hessel, H. Freimuth, M. Stadel, M. Lacher, W. Ehrfeld, Fabrication of Complex Ceramic Microstructures from Powder Ceramics and Preceramic Polymers, *Tagungsband Micro Materials (Micro Mat* '*97*), 16-18.04.1997, Berlin, 370ff.
**[5]** Vaahs, M. Brück, W.D.G. Böcker, Polymer-derived Silicon Nitride and Silicon Carbonitride Fibers, *Adv. Mater*., **4(3),** 224ff (1992).
[6] JP 05088373

## Patentansprüche

1. Verfahren zur Herstellung von Klein- und Mikroteilen aus Keramik durch Lithographie, **gekennzeichnet durch** folgende Verfahrensschritte:
a) Aufbringen eines präkeramischen, siliziumhaltigen Polymers auf ein hochtemperaturfestes Substrat und anschließender Trocknung bei Raumtemperatur,
b) Bildhafte Belichtung des mit dem präkeramischen Polymer beschichteten Substrats mit elektromagnetischer Strahlung mit einer Wellenlänge < 400 nm,
c) Entwicklung des belichteten Filmes in einem organischen Lösungsmittel,
d) Pyrolyse bei einer Temperatur über 900 °C und anschließende Sinterung des entwickelten Kunststofffilmes zu einem formstabilen dreidimensionalen Formkörper bei einer Temperatur über 1600 °C.

2. Verfahren nach Anspruch 1, **dadurch gekennzeichnet, daß** das präkeramische, siliziumhaltige Polymer Bor- und/oder Kohlenstoff- und /oder Phosphor- und/oder Sauerstoff- und/oder Stickstoff- und/oder Wasserstoffatome enthält.

3. Verfahren nach Anspruch 1 oder 2, **dadurch gekennzeichnet, daß** das präkeramische Polymer in Reinform oder als Lösung in einem Lösungsmittel mittels Schleuderverfahren oder Aufstreichen SpinCoating und/oder SpinCasten, auf ein hochtemperaturfestes Substrat aufgebracht wird.

4. Verfahren nach einem der Ansprüche 1 bis 3, **dadurch gekennzeichnet, daß** als elektromagnetische Strahlung paralleles UV-Licht mit einer Wellenlänge zwischen 300 und 400 nm oder Synchrotronstrahlung verwendet wird.

5. Verfahren nach einem der Ansprüche 1 bis 4, **dadurch gekennzeichnet, daß** das mit dem präkeramischen Polymer beschichtete Substrat nach der Belichtung in einem organischem Lösungsmittel geeigneter polarität (z. B. Aceton, Chloroform, Dioxan, Isopropanol, Toluol) entwickelt wird, wobei die unbelichteten Filmbereiche im verwendeten Lösungsmittel löslich sind.

6. Verfahren nach einem der Ansprüche 1 bis 5, **dadurch gekennzeichnet, daß** die Pyrolyse bei einer Temperatur zwischen 900 und 1200 °C über eine Dauer von 0,5 - 2 Stunden unter Vakuum und/oder einer Inert- und/oder Stickstoff- und/oder einer Ammoniakatmosphäre zur Keramik durchgeführt wird.

7. Verfahren nach einem der Ansprüche 1 bis 6, **dadurch gekennzeichnet, daß** die pyrolisierte keramische Mikrostruktur Temperatur zwischen 1600 und 2000 °C, über eine Dauer von 0,5 - 2 Stunden bei Temperaturen bis 2000 °C zur formstabilen Keramik gesintert wird.

## Claims

1. Method for producing small and micro-sized ceramic parts by means of lithography, **characterised by** the following method steps:
a) application of a pre-ceramic polymer containing silicon to a high temperature-resistant substrate and subsequent drying at room temperature,
b) pictorial exposure of the substrate which is coated with the pre-ceramic polymer to electromagnetic radiation with a wavelength < 400 nm,
c) development of the exposed film in an organic solvent,
d) pyrolysis at a temperature above 900°C and subsequent sintering of the developed plastic material film to form a dimensionally stable three-dimensional moulded body at a temperature above 1600°C.

2. Method according to claim 1, **characterised in that** the pre-ceramic polymer containing silicon contains boron and/or carbon and/or phosphorus and/or oxygen and/or nitrogen and/or hydrogen atoms.

3. Method according to claim 1 or 2, **characterised in that** the pre-ceramic polymer is applied in pure form or as a solution in a solvent to a high temperature-resistant substrate by means of a centrifugal method or spreading-on, spin-coating and/or spin-casting.

4. Method according to one of the claims 1 to 3, **characterised in that**, as electromagnetic radiation, parallel UV light with a wavelength between 300 and 400 nm or synchrotron radiation is used.

5. Method according to one of the claims 1 to 4, **characterised in that** the substrate, which is coated with the pre-ceramic polymer, is developed after exposure in an organic solvent of suitable polarity, (e.g. acetone, chloroform, dioxane, isopropanol, toluene), the unexposed film regions being soluble in the used solvent.

6. Method according to one of the claims 1 to 5, **characterised in that** the pyrolysis is implemented to form the ceramic at a temperature between 900 and 1200°C over a duration of 0.5 - 2 hours under vacuum and/or an inert and/or nitrogen and/or an ammonia atmosphere.

7. Method according to one of the claims 1 to 6, **characterised in that** the pyrolysed ceramic microstructure, temperature between 1600 and 2000°C, is sintered to form the dimensionally stable ceramic over a duration of 0.5 - 2 hours at temperatures up to 2000°C.

## Revendications

1. Procédé de production de petites pièces et de micropièces de céramique par lithographie,
**caractérisé par**
les étapes opératoires suivantes :
a) apport d'un polymère pré-céramique contenant du silicium sur un substrat solide à haute température, puis séchage à la température ambiante,
b) éclairage selon un dessin du substrat revêtu avec le polymère pré-céramique au moyen d'un rayonnement électromagnétique d'une longueur d'onde < 400 nm,
c) développement de la pellicule éclairée dans un solvant organique,
d) pyrolyse à une température supérieure à 900 °C puis frittage de la pellicule de matière synthétique développée pour donner un article tridimensionnel de forme stable à une température supérieure à 1600°C.

2. Procédé selon la revendication 1,
**caractérisé en ce que**
le polymère pré-céramique contenant du silicium contient des atomes de bore et/ou de carbone et/ou de phosphore et/ou d'oxygène et/ou d'azote et/ou d'hydrogène.

3. Procédé selon la revendication 1 ou 2,
**caractérisé en ce que**
le polymère pré-céramique est déposé sous forme pure ou sous forme de solution dans un solvant au moyen d'un procédé à barbotine ou par enduction, spin coating et/ou spin casten, sur un substrat solide à haute température.

4. Procédé selon l'une des revendications 1 à 3,
**caractérisé en ce qu'**
on utilise comme rayonnement électromagnétique une lumière UV parallèle ayant une longueur d'onde comprise entre 300 et 400 nm ou un rayonnement produit par un synchrotron.

5. Procédé selon l'une des revendications 1 à 4,
**caractérisé en ce qu'**
on développe le substrat revêtu du polymère pré-céramique, après éclairage, dans un solvant organique de polarité appropriée, (par exemple l'acétone, le chloroforme, le dioxanne, l'isopropanol, le toluène), les zones de la pellicule non éclairées étant solubles dans le solvant employé.

6. Procédé selon l'une des revendications 1 à 5,
**caractérisé en ce qu'**
on conduit la pyrolyse à une température comprise entre 900 et 1200 °C pendant une durée de 0,5 à 2 heures sous vide et/ou sous une atmosphère inerte et/ou d'azote et/ou d'ammoniac pour donner une céramique.

7. Procédé selon l'une des revendications 1 à 6,
**caractérisé en ce qu'**
on fritte la microstructure de céramique pyrolysée à une température comprise entre 1600 et 2000°C, pendant une durée de 0,5 à 2 heures à des températures allant jusqu'à 2000°C pour donner une céramique de forme stable.
